# EUROPÄISCHE PATENTSCHRIFT

(11) **EP 1 501 190 B1**
(45) Veröffentlichungstag und Bekanntmachung des Hinweises auf die Patenterteilung: **07.10.2009**
(21) Anmeldenummer: 03016900.7
(22) Anmeldetag: 24.07.2003
(51) Int. Cl.: H03G 9/02

(54) **Verfahren und Vorrichtung zum Entzerren eines mit einem äusseren Störsignal behafteten Audiosignals**
Method and device for equalization of an audio signal distorted by ambient noise
Procédé et dispositif pour égaliser un signal audio comprenant un signal de bruit externe

(43) Veröffentlichungstag der Anmeldung: 26.01.2005
(73) Patentinhaber: Palm, Inc., Sunnyvale, CA 94085-2801 (US)
(72) Erfinder: Klinke, Stefano Ambrosius, Dr., 50169 Kerpen (DE)
(74) Vertreter: Samson & Partner

(56) Entgegenhaltungen:
- EP-A- 0 767 570
- DE-A- 2 456 445
- GB-A- 2 284 970
- US-A- 4 641 344
- US-A- 4 868 881
- PATENT ABSTRACTS OF JAPAN vol. 1996, no. 07, 31. Juli 1996 (1996-07-31) -& JP 08 070228 A (TOSHIBA CORP), 12. März 1996 (1996-03-12)

## Beschreibung

Die Erfindung bezieht sich auf ein Verfahren und eine Vorrichtung zum Entzerren eines mit einem äußeren Störsignal behafteten Audiosignals, und zwar insbesondere zum Erhöhen einer Verständlichkeit des Audiosignals, nach dem Oberbegriff des Anspruchs 1, bzw. Anspruchs 4, wenn es über eine akustische Wiedergabevorrichtung ausgestrahlt wird.

Ein Anwendungsgebiet der Erfindung ist beispielsweise der Bereich mobiler Kommunikationsendgeräte, die üblicher Weise mit einer akustischen Wiedergabevorrichtung in Form eines Lautsprechers zur Ausstrahlung von Audiosignalen ausgestattet sind.

Zum Erhöhen einer Verständlichkeit des Audiosignals, das mit einem Störsignal behaftet ist, wird derzeit wie folgt vorgegangen: Für die verwendete akustische Wiedergabevorrichtung wird eine automatische Lautstärkeneinstellung eingesetzt, die als ein Eingangssignal einen äußeren Geräuschpegel, der das Störsignal repräsentiert, erhält. Mit steigendem Geräuschpegel wird eine Lautstärke der akustischen Wiedergabevorrichtung breitbandig erhöht, um eine Verständlichkeit des Audiosignals zu verbessern.

Die bekannte Vorgehensweise hat jedoch den Nachteil, dass eine höhere Lautstärke der akustischen Wiedergabevorrichtung bei Geräten wie mobilen Kommunikationsendgeräten, die sowohl einen Lautsprecher als auch ein Mikrophon aufweisen, zu einer größeren Kopplung zwischen diesen beiden Komponenten führt. Eine Folge ist, dass von dem Mikrophon aufgenommene akustische Signale bei erhöhter Lautstärke des Lautsprechers zunehmend gestört werden.

Aus der JP 08 070228 A sind ein Verfahren nach dem Oberbegriff des Anspruchs 1 sowie eine Vorrichtung nach dem Oberbegriff von Anspruch 4 bekannt. Eine verbesserte Entzerrung des Audiosignals stellt nach diesem Stand der Technik auf einer alleinigen Betrachtung von Frequenzlagen von Störsignalmaxima ab.

Ausgehend hiervon liegt der Erfindung die Aufgabe zugrunde, ein Verfahren und eine Vorrichtung zum Entzerren eines mit einem Störsignal behafteten Audiosignals anzugeben, bei dem eine Verständlichkeit des Audiosignals bei geringen Lautstärkeänderungen für das Audiosignal verbessert wird.

Diese Aufgabe wird hinsichtlich des Verfahrens gelöst durch ein Verfahren zum Entzerren eines mit einem Störsignal behafteten Audiosignals mit den Merkmalen des Patentanspruchs 1.

Der Erfindung liegt die Erkenntnis zugrunde, dass zum Erhöhen einer Verständlichkeit des Audiosignals nicht notwendigerweise eine Gesamtlautstärke des Audiosignals zu Erhöhen ist, d. h. über einen gesamten Frequenzbereich des Audiosignals eine Lautstärkeerhöhung stattfindet.

Nach der Erfindung ist es vorgesehen, das Audiosignal aufgrund lokaler Maxima des Störsignals zum Erhöhen einer Verständlichkeit des Audiosignals zu entzerren. Es wird auf der Basis der Bestimmung der lokalen Maxima des Störsignals nicht für den gesamten Frequenzbereich, sondern für ausgewählte Frequenzintervalle, die für eine Verständlichkeit des Audiosignals besonders maßgeblich sind, eine Entzerrung vorgenommen. Daher ist es im Unterschied gegenüber dem Stand der Technik nicht erforderlich, eine gesamte Intensität des Audiosignals zu erhöhen, so dass auch eine Kopplung zwischen einem Lautsprecher, über den das entzerrte Audiosignal wiedergegeben wird, und einem Mikrophon (Mobiltelefon) gegenüber dem Stand der Technik vermindert ist.

Für eine Entzerrung des Audiosignals nach dem Schritt d) kann es vorzuziehen sein, sie in dem Teil der Frequenzintervalle aufgrund einer psycho-akustisch motivierten Entzerrungskurve zu entzerren. Psycho-akustisch motivierte Entzerrungskurven zeichnen sich dadurch aus, dass sie eine Frequenzabhängigkeit einer Empfindlichkeit des menschlichen Ohres für akustische Signale wiedergeben. So weist das menschliche Ohr in einem Frequenzbereich von 2 bis 5 kHz eine besonders hohe Empfindlichkeit auf. Dies bedeutet, dass bei einem Schalldruckpegel, der über einen Frequenzbereich konstant ist, die vom menschlichen Ohr empfundene Lautstärke einer psycho-akustisch motivierten Entzerrungskurve folgt.

Da es im Sinne der Erfindung liegt, eine Verständlichkeit des Audiosignals mit möglichst geringem Anheben des Schalldruckpegels zu verbessern, ist die Heranziehung psycho-akustisch motivierter Entzerrungskurven von Vorteil.

Nach der Erfindung werden in dem Schritt b) auch Frequenzintervalle bestimmt, denen lokale Maxima des Audiosignals zugeordnet sind, so dass Informationen sowohl über Frequenzintervalle mit lokalen Maxima des Störsignals als auch über Frequenzintervalle mit lokalen Maxima des Audiosignals gewonnen werden.

In einem Verfahrensschritt, der in den Schritt b) integriert sein kann, werden Überlappungen dieser beiden Arten von Frequenzintervallen erfasst.

Die derart gewonnenen Informationen über die Lage der lokalen Maxima des Audiosignals und des Störsignals werden für eine Entzerrung nach Schritt c) derart ausgenutzt, dass das Audiosignal wenigstens in einem Teil der Frequenzintervalle der lokalen Maxima des Audiosignals, die mit Frequenzintervallen der lokalen Maxima des Störsignals überlappen, verstärkt wird. Bei diesem Ausführungsbeispiel bestimmen somit die den lokalen Maxima des Audiosignals zugeordneten Frequenzintervalle, welche Frequenzen einer Entzerrung unterzogen werden.

Dem zuletzt beschriebenen Ausführungsbeispiel liegt zugrunde, dass gerade die lokalen Maxima des Audiosignals für die Verständlichkeit von besonderer Bedeutung sind. Nach dem Ausführungsbeispiel wird ein Signal-zu-Rauschen-Verhältnis nur für diejenigen Frequenzintervalle verbessert, die für eine Verständlichkeit verantwortlich sind.

Die oben genannte Aufgabe wird hinsichtlich der Vorrichtung gelöst durch eine Vorrichtung nach den Merkmalen von Anspruch 4.

Besondere Merkmale und Vorteile der Vorrichtung gemäß besonderen Ausführungsbeispielen gehen bereits aus der oben gegebenen Beschreibung des Verfahrens zum Entzerren eines Audiosignals hervor. Die Vorrichtung kann insbesondere in Form eines Halbleiterchips realisiert sein, der eine Software enthält, die zur Durchführung des Verfahrens angepasst ist.

Ausführungsbeispiele der Erfindung werden nachfolgend anhand der Zeichnungen noch näher beschrieben. Es zeigen:
- Figur 1:: eine schematische Darstellung eines Frequenzspektrums eines wiederzugebenden Audiosignals
- Figur 2:: eine schematische Darstellung eines Frequenzspektrums eines äußeren Störsignals
- Figur 3:: eine schematische Darstellung eines aus dem Audiosignal von Figur 1 hervorgegangenen entzerrten Signals, basierend auf einem ersten Ausführungsbeispiel eines Entzerrungsverfahrens und
- Figur 4:: eine schematische Darstellung eines aus dem Audiosignal von Figur 1 hervorgegangenen entzerrten Signals, basierend auf einem zweiten Ausführungsbeispiel eines Entzerrungsverfahrens.

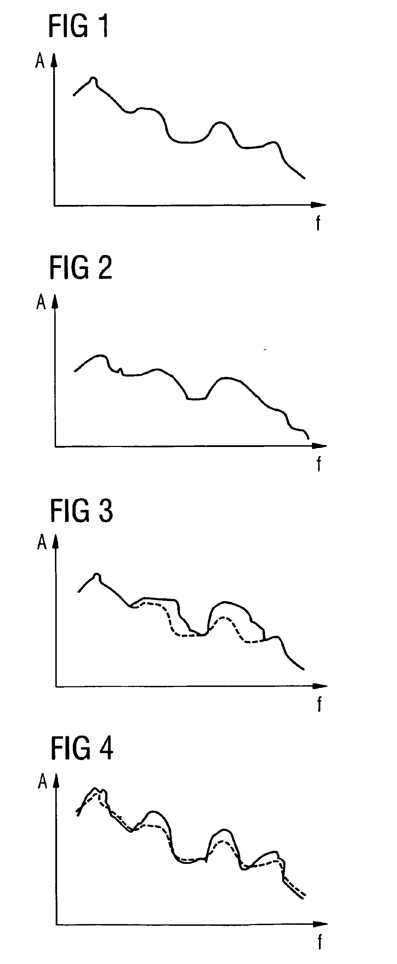

In der Figur 1 ist ein Frequenzspektrum eines Audiosignals in schematischer Darstellung gezeigt, wobei das Audiosignal beispielsweise zur Wiedergabe über einen Lautsprecher eines Mobiltelefons vorgesehen ist. Das Audiosignal enthält sowohl Signalanteile, die als Nutzsignal bezeichnet werden können und auf empfangene Sprachsignale zurückgehen. In der Praxis wird das Audiosignal von Störgeräuschen äußerer Geräuschsquellen überlagert, die ein äußeres Störsignal bilden.

Das in Figur 1 dargestellte Audiosignal enthält ein Störsignal, das in Figur 2 in seinem Frequenzverlauf wiedergegeben ist. Es ist ohne weiteres ersichtlich, dass das Störsignal eine Mehrzahl lokaler Maxima aufweist, die naturgemäß eine Verständlichkeit des Audiosignals verschlechtern.

Nach einem bekannten Verfahren zum Entzerren des mit dem Störsignal behafteten Audiosignals wird wie folgt vorgegangen:

In einem Verfahrensschritt a) wird das in Figur 1 dargestellte Audiosignal über einen vorgegebenen Frequenzbereich erfasst. Für das in Figur 2 dargestellte Störsignal erfolgt ebenfalls eine Erfassung des zugehörigen Spektrums. Die Erfassung des Störsignal-Frequenzspektrums erfolgt in einer Pause für das Nutzsignal, im Falle eines Telefongesprächs innerhalb einer Sprachpause.

In einem Schritt b) werden Frequenzintervalle in dem vorgegebenen Frequenzbereich bestimmt, in denen lokale Maxima des Störsignals vorliegen. Dabei kann beispielsweise für das Feststellen eines lokalen Maximums ein vorherbestimmtes Signal-zu-Rauschen-Verhältnis zugrundegelegt werden. Dieses Verhältnis legt eine Schwelle fest, bei deren Überschreiten ein lokales Maximum des Störsignals für eine später erfolgende Entzerrung des Audiosignals herangezogen wird.

Allgemein wird in einem Schritt c) das Audiosignal aufgrund der in Schritt b) bestimmten Frequenzintervalle für die lokalen Maxima des Störsignals zum Erhöhen einer Verständlichkeit des Audiosignals entzerrt. Diese Vorgehensweise wird bei sämtlichen Ausführungsformen des Verfahrens eingehalten. Im hier dargelegten Verfahren wird das in Figur 1 dargestellte Audiosignal in denjenigen Frequenzintervallen verstärkt, welche durch die Frequenzlagen der lokalen Maxima des Störsignals festgelegt sind. Eine tatsächliche Breite solcher Frequenzintervalle kann von einem jeweiligen Signal-zu-Rauschen-Verhältnis bei der Frequenz eines lokalen Maximums, eine Frequenzbreite des lokalen Maximums o. ä. abhängen.

Die Entzerrung des Audiosignals nach dem Schritt c) erfolgt aufgrund einer psycho-akustisch motivierten Entzerrungskurve, die berücksichtigt, dass das menschliche Ohr für verschiedene akustische Frequenzen unterschiedlich empfindlich ist. Dies bedeutet, dass in dem Fall eines lokalen Maximums des Störsignals in einem Frequenzbereich, bei dem das menschliche Ohr besonders empfindlich ist, eine Verstärkung des Frequenzintervalls mit vergleichsweise geringer zusätzlicher elektrischer Leistung bewerkstelligt werden kann.

In der Figur 3 ist mit durchgezogener Linie das nach dem vorstehend erläuterten Verfahren entzerrte Audiosignal von Figur 1 dargestellt, wobei abweichende Frequenzverläufe des ursprünglichen Audiosignals in der Figur 3 gestrichelt gezeigt sind. Es ist ersichtlich, dass das Audiosignal im Bereich lokaler Maxima des Störsignals von Figur 2 mit Hilfe des Entzerrungsverfahrens verstärkt worden ist.

Bei einem erfindungsgemäßen Ausführungsbeispiel eines Verfahrens zum Entzerren des mit dem Störsignal von Figur 2 behafteten Audiosignals von Figur 1 werden die oben erläuterten Teilschritte a) bis b) sowie der Teilschritt d) ungeändert oder ergänzt durchgeführt.

Abweichungen ergeben sich hinsichtlich des Teilschrittes c). Während bei dem ersten Verfahren eine Frequenzverteilung des Störsignals diejenigen Frequenzintervalle unmittelbar bestimmt, die in dem Audiosignal zu entzerren sind, ergeben sich bei dem zweiten Verfahren demgegenüber Änderungen.

Zunächst wird in dem Schritt b) zusätzlich auch eine Bestimmung von Frequenzintervallen vorgenommen, denen lokale Maxima des Audiosignals selbst zugeordnet sind, so dass nach Abschluss des Teilschrittes b) sowohl Informationen über Frequenzintervalle lokaler Maxima des Störsignals als auch Informationen über Frequenzintervalle lokaler Maxima des Audiosignals vorliegen.

Bei dem Teilschritt c) wird im Vergleich zu dem ersten Verfahren zusätzlich festgestellt, ob Überlappungen von Frequenzintervallen, die lokalen Maxima des Störsignals zugeordnet sind, mit Frequenzintervallen, die den lokalen Maxima des Audiosignals zugeordnet sind, vorliegen. Auch für einen Überlappungsgrad solcher Frequenzintervalle kann im Vorhinein ein Schwellwert festgelegt sein.

In Schritt c) wird nunmehr wenigstens in einem Teil der Frequenzintervalle der lokalen Maxima des Audiosignals, die mit den ermittelten Frequenzintervallen der lokalen Maxima des Störsignals überlappen, eine Entzerrung vorgenommen, wobei wiederum psycho-akustisch motivierte Entzerrungskurven einbezogen sein können. Es erfolgt eine Verstärkung des Audiosignals für die eine Überlappung zeigenden Frequenzintervalle der lokalen Maxima des Audiosignals. Dies wird auch anhand von Figur 4 deutlich, die in Form einer durchgezogenen Linie ein entzerrtes Audiosignal und mit gestrichelter Linie einen abweichenden Verlauf des ursprünglichen Audiosignals von Fig. 1 zeigt. Es ist ersichtlich, dass die Frequenzintervalle, bei denen eine Entzerrung vorgenommen worden ist, an die Frequenzlagen der lokalen Maxima des Audiosignals gekoppelt ist.

Beiden Verfahren ist gemeinsam, dass grundsätzlich von den Lagen der Frequenzintervalle der lokalen Maxima des Störsignals ausgegangen wird. Bei dem ersten Verfahren werden die Frequenzintervalle, die tatsächlich einer Entzerrung unterzogen werden, durch gerade diese Frequenzintervalle des Störsignals festgelegt, während im zweiten Verfahren die zu entzerrenden Frequenzintervalle von den Frequenzlagen der lokalen Maxima des Audiosignals selbst bestimmt werden. Selbstverständlich sind auch Zwischenlösungen denkbar, bei denen die zu entzerrenden Frequenzintervalle anhand der Frequenzlagen sowohl der Störsignal-Frequenzintervalle als auch der Audiosignal-Frequenzintervalle, jeweils bezogen auf die lokalen Maxima, festgelegt werden.

Zur Durchführung des Verfahrens ist eine Vorrichtung einzusetzen, die eine erste Erfassungseinrichtung für das Spektrum des Audiosignals über den vorgegebenen Frequenzbereich aufweist, während für das Störsignal eine weitere Erfassungseinrichtung zur Aufnahme des Spektrums vorhanden ist. Die Vorrichtung ist außerdem zur Durchführung der oben angegebenen Verfahrensschritte b) und c) hergerichtet und weist dafür eine Bestimmungseinrichtung zur Durchführung des Schrittes b) und eine Entzerrungseinrichtung zur Durchführung des Schrittes c) auf.

## Patentansprüche

1. Verfahren zum Entzerren eines mit einem äußeren Störsignal behafteten Audiosignals mit den Schritten:
a) Erfassen eines Spektrums des Audiosignals und eines Spektrums des Störsignals über einen vorgegebenen Frequenzbereich,
b) Bestimmen von Frequenzintervallen in dem Frequenzbereich, denen lokale Maxima des Störsignals zugeordnet sind,
c) Entzerren des Audiosignals aufgrund der in Schritt b) bestimmten Frequenzintervalle für lokale Maxima des Störsignals zum Erhöhen einer Verständlichkeit des Audiosignals, und
d) Wiedergeben des entzerrten Audiosignals,
**dadurch gekennzeichnet, dass**
in Schritt b) auch Frequenzintervalle bestimmt werden, denen lokale Maxima des Audiosignals zugeordnet sind, in Schritt c) Überlappungen von Frequenzintervallen, die den lokalen Maxima des Störsignals zugeordnet sind, mit Frequenzintervallen, die den lokalen Maxima des Audiosignals zugeordnet sind, erfasst werden und in Schritt c) das Audiosignal wenigstens in einem Teil der Frequenzintervalle der lokalen Maxima des Audiosignals, die mit Frequenzintervallen der lokalen Maxima des Störsignals überlappen, verstärkt wird.

2. Verfahren nach Anspruch 1,
bei dem das Audiosignal in Schritt c) in wenigstens einem Teil der Frequenzintervalle verstärkt wird.

3. Verfahren nach Anspruch 1 oder 2,
bei dem das Audiosignal in Schritt c) in dem Teil der Frequenzintervalle aufgrund einer psycho-akustisch motivierten Entzerrungskurve entzerrt wird.

4. Vorrichtung zum Entzerren eines mit einem Störsignal
behafteten Audiosignals, mit
einer Audiosignalerfassungseinrichtung zum Erfassen eines Spektrums des Audiosignals über einen vorgegebenen Frequenzbereich,
einer Störsignal-Erfassungseinrichtung zum Erfassen eines Spektrums des Störsignals über einen vorgegebenen Frequenzbereich,
einer Bestimmungseinrichtung zum Bestimmen von Frequenzintervallen in dem Frequenzbereich, denen lokale Maxima des Störsignals zugeordnet sind, und
einer Entzerrungseinrichtung zum Entzerren des Audiosignals aufgrund der bestimmten Frequenzintervalle für lokale Maxima des Störsignals,
**dadurch gekennzeichnet, dass**
die Bestimmungseinrichtung zum Bestimmen von Frequenzintervallen ausgebildet ist, denen lokale Maxima des Audiosignals zugeordnet sind, und
die Entzerrungseinrichtung zum Erfassen von Überlappungen von Frequenzintervallen, die den lokalen Maxima des Störsignals zugeordnet sind, mit Frequenzintervallen, die den lokalen Maxima des Audiosignals zugeordnet sind,
und zum Verstärken des Audiosignals in wenigstens einem Teil der Frequenzintervalle der lokalen Maxima des Audiosignals, die mit Frequenzintervallen der lokalen Maxima des Störsignals überlappen, ausgebildet ist.

## Claims

1. Method for equalizing an audio signal affected by an external noise signal with the steps:
a) recording of a spectrum of the audio signal and a spectrum of the noise signal over a prescribed frequency range,
b) definition of frequency intervals in the frequency range to which local maxima of the noise signal are assigned,
c) equalization of the audio signal on the basis of the frequency intervals defined in step b) for local maxima of the noise signal in order to increase the comprehensibility of the audio signal, and
d) reproduction of the equalized audio signal,
**characterized in that,**
in step b) frequency intervals are also defined to which local maxima of the audio signal are assigned,
in step c), overlaps are recorded of frequency intervals which are assigned to the local maxima of the noise signal with frequency intervals which are assigned to the local maxima of the audio signal, and
in step c), the audio signal is amplified in at least a part of the frequency intervals of the local maxima of the audio signal which overlap with frequency intervals of the local maxima of the noise signal.

2. Method according to Claim 1,
in which the audio signal in step c) is amplified in at least a part of the frequency intervals.

3. Method according to Claim 1 or 2,
in which the audio signal in step c) is equalized in part of the frequency intervals on the basis of a psychoacoustically motivated equalization curve.

4. Device for equalizing an audio signal affected by a noise signal, with
an audio signal recording device to record a spectrum of the audio signal over a prescribed frequency range,
a noise signal recording device to record a spectrum of the noise signal over a prescribed frequency range,
a definition device to define frequency intervals in the frequency range, to which local maxima of the noise signal are assigned, and
an equalization device to equalize the audio signal on the basis of the defined frequency intervals for local maxima of the noise signal,
**characterized in that**
the definition device is designed to define frequency intervals to which local maxima of the audio signal are assigned, and
the equalization device is designed to record overlaps of frequency intervals which are assigned to the local maxima of the noise signal with frequency intervals which are assigned to the local maxima of the audio signal, and to amplify the audio signal in at least a part of the frequency intervals of the local maxima of the audio signal which overlap with frequency intervals of the local maxima of the noise signal.

## Revendications

1. Procédé d'égalisation d'un signal audio affecté par un signal de bruit extérieur, comprenant les étapes :
a) saisie d'un spectre du signal audio et d'un spectre du signal de bruit sur une gamme de fréquences prédéfinie,
b) détermination d'intervalles de fréquence, dans la gamme de fréquences, auxquels des maxima locaux du signal de bruit sont associés,
c) égalisation du signal audio sur la base des intervalles de fréquence déterminés dans l'étape b) pour des maxima locaux du signal de bruit pour augmenter l'intelligibilité du signal audio et
d) reproduction du signal audio égalisé,
**caractérisé en ce que,**
dans l'étape b), on détermine également des intervalles de fréquence auxquels sont associés des maxima locaux du signal audio, dans l'étape c), on détecte des chevauchements d'intervalles de fréquence associés aux maxima locaux du signal de bruit avec des intervalles de fréquence associés aux maxima locaux du signal audio et dans l'étape c), on amplifie le signal audio au moins dans une partie des intervalles de fréquence des maxima locaux du signal audio qui se chevauchent avec des intervalles de fréquence des maxima locaux du signal de bruit.

2. Procédé selon la revendication 1,
dans lequel le signal audio est amplifié dans l'étape c) dans au moins une partie des intervalles de fréquence.

3. Procédé selon la revendication 1 ou 2,
dans lequel le signal audio est égalisé dans l'étape c) dans la partie des intervalles de fréquence sur la base d'une courbe d'égalisation psycho-acoustique.

4. Dispositif pour l'égalisation d'un signal audio affecté par un signal de bruit, comprenant :
un dispositif de saisie de signal audio pour la saisie d'un spectre du signal audio sur une gamme de fréquences prédéfinie,
un dispositif de saisie de signal de bruit pour la saisie d'un spectre du signal de bruit sur une gamme de fréquences prédéfinie,
un dispositif de détermination pour déterminer des intervalles de fréquence, dans la gamme de fréquences, auxquels des maxima locaux du signal de bruit sont associés et
un dispositif d'égalisation pour égaliser le signal audio sur la base des intervalles de fréquence pour des maxima locaux du signal de bruit déterminés,
**caractérisé en ce que**
le dispositif de détermination est exécuté pour déterminer des intervalles de fréquence auxquels sont associés des maxima locaux du signal audio et
le dispositif d'égalisation est exécuté pour détecter des chevauchements d'intervalles de fréquence associés aux maxima locaux du signal de bruit avec des intervalles de fréquence associés aux maxima locaux du signal audio et pour amplifier le signal audio dans au moins une partie des intervalles de fréquence des maxima locaux du signal audio qui se chevauchent avec des intervalles de fréquence des maxima locaux du signal de bruit.
